# EUROPEAN PATENT APPLICATION

(11) **EP 2 157 617 A2**
(43) Date of publication of application: **24.02.2010**
(21) Application number: 09168063.7
(22) Date of filing: 18.08.2009
(51) Int. Cl.: H01L 31/0232

(54) **Solar cell and manufacturing method thereof**

(30) Priority: 19.08.2008 TW 97131523
(71) Applicant: Advanced Optoelectronic Technology Inc., No.13, Gongye 5th Road Hsinchu Industrial Park Hukou Township Hsinchu County 303 (TW)
(72) Inventor: Lin, Hung Chin, 303, Hukou Township, Hsinchu County (TW); Chang, Chia-Chen, 303, Hukou Township, Hsinchu County (TW)
(74) Representative: 2K Patentanwälte Blasberg Kewitz & Reichel

(57) **Abstract**

The invention discloses a solar cell (200) including a substrate (220), a chip (210), a convex lens structure (240), and an infrared filter (250). The substrate has a groove (205) in which the chip is placed. The chip (210) can transform light energy into electric energy. Furthermore, the convex lens structure (240) is placed over the groove (205). The infrared filter (250) is attached to the incident surface (242) of the convex lens structure (240).

## Description

### BACKGROUND OF THE INVENTION

### FIELD OF THE INVENTION

The present invention relates to a solar cell, and relates more particularly to a solar cell capable of condensing light.

### DESCRIPTION OF THE RELATED ART

Recently, the increase of the production of carbon dioxide contributes to the greenhouse effect and the high price of oil, so more attention is being directed toward renewable energy. The related renewable energy technologies comprise solar energy, wind energy, geothermal energy, hydropower, tidal energy, ocean thermal energy conversion and biomass energy. The technology of solar energy is widely applied to many fields.

There are many types of solar cells currently on the market. Silicon solar cells, for example, were gradually developed and manufactured first by American Bell Laboratories during the seventh decade of the 20th century. The operation principle of such silicon solar cells is based on the photovoltaic effect. Another type of solar cell is the dye sensitized solar cell which was developed by the Swiss scientist Gratzel later in the ninth decade the 20th century. The operation principle of the dye sensitized solar cells is that electron jump is excited after the molecules absorb sunlight (photons) and the electrons are rapidly transited to a titanium dioxide layer, leaving holes in the dyes. The electrons are then distributed to the conductive thin film, and are transited to the electrodes at opposite sides through an external circuit. The oxidative dyes are reduced by electrolyte. The oxidative electrolyte is reduced to a ground state by receiving electrons from the electrodes. Accordingly, the complete course of electron transition is finished.

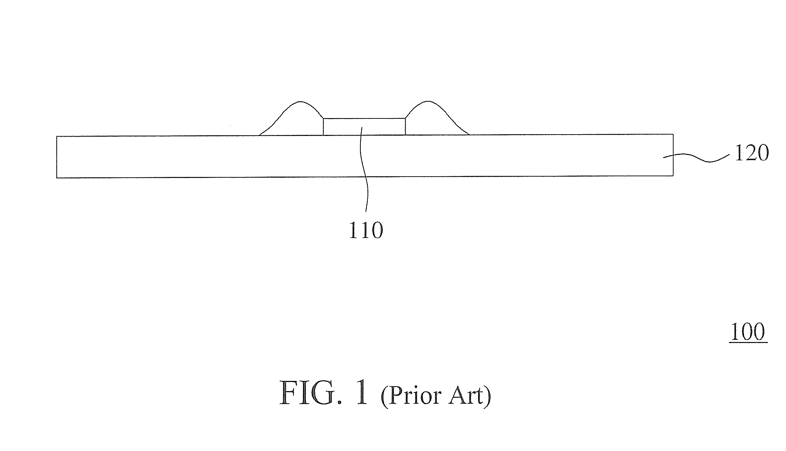

FIG. 1 shows a conventional solar energy cell. A solar energy cell 100 comprises a chip 110 and a substrate 120. The chip 110 is mounted on the substrate 120. The chip 110 can transform solar energy into electrical energy. However, both solar energy cells and dye sensitized solar cells have poor rates of photo-energy transformation. Therefore, the area of the chip 110 needs to be increased so that the absorption area of light is also increased. In addition, the infrared rays of solar light can easily cause a thermal accumulation on the substrate 120 that may damage the chip 110.

Therefore, development of a method to improve the photo-energy absorption of the chip 110 while avoiding the thermal accumulation of the substrate 120 is an important issue for the persons ordinarily skilled in the art.

### SUMMARY OF THE INVENTION

The present invention provides a solar cell. The solar cell can absorb more light energy than prior art solar cells without increasing the area of the chip.

One aspect of the present invention is to provide a solar cell. The solar cell includes a substrate, a chip, a convex lens structure, and an infrared filter. The substrate has a groove in which the chip is placed. The chip can transform light energy into electric energy. Furthermore, the convex lens structure is placed over the groove. The infrared filter is attached on the incident surface of the convex lens structure.

In the aforesaid solar cell, the material of the convex lens structure is silicone.

In the aforesaid solar cell, the material of the convex lens structure is glass.

In the aforesaid solar cell, the focus of the convex lens structure is at the chip.

In the aforesaid solar cell, filler is filled in the groove and covers the chip.

In the aforesaid solar cell, the material of the filler is silicone.

One aspect of the present invention is to provide a method for manufacturing a solar cell, comprising the steps of: providing a substrate having a groove; placing a chip in the groove of the substrate; placing a convex lens structure above the groove; and attaching an infrared filter to the incident surface of the convex lens structure.

As to the method for manufacturing a solar cell, further steps after the chip is placed in the groove of the substrate and before the convex lens structure is placed above the groove are as follows: filling the groove with filler to cover the chip, wherein the material of the filler is silicone. The convex lens structure is formed on the filler by injection molding.

In the method for manufacturing a solar cell, the material of the convex lens structure is glass and is disposed on the filler by adhesive.

Because the convex lens structure capable of condensing light is disposed above the chip, incident sunlight can be focused on the chip. Therefore, even the chip with a smaller area can absorb much more light. Because the infrared filter is attached to the incident surface of the convex lens structure, the infrared band of sunlight can be filtered by the infrared filter. The thermal energy does not easily accumulate on the substrate so that the chip thereon has a long working life.

To better understand the above-described objectives, characteristics and advantages of the present invention, embodiments, with reference to the drawings, are provided for detailed explanation.

### BRIEF DESCRIPTION OF THE DRAWINGS

The invention will be described according to the appended drawings in which:
FIG. 1 illustrates a conventional solar energy cell;
FIG. 2 illustrates a solar cell in accordance with one embodiment of the present invention; and
FIGS. 3A-3E illustrate the manufacturing steps of the solar cell.

### DETAILED DESCRIPTION OF THE INVENTION

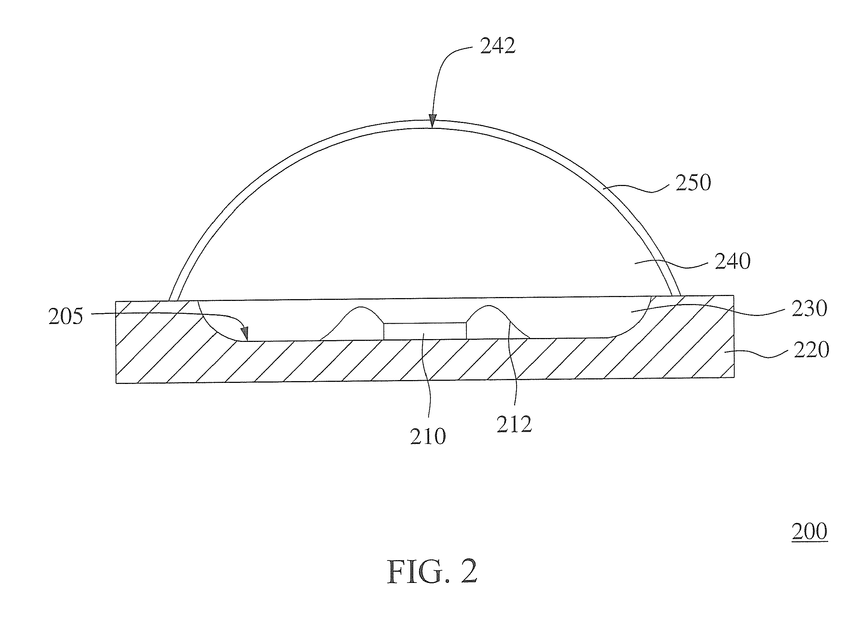

FIG. 2 illustrates a solar cell in accordance with one embodiment of the present invention. The solar cell 200 comprises a substrate 220, a chip 210, a convex lens structure 240, and an infrared filter 250. The substrate 220 has a groove 205 in which the chip 210 is placed. The chip can transform light energy into electric energy through, for example, the photovoltaic effect or the dye sensitization.

In addition, the manufacture of the solar cell 200 can optionally include filling the groove 205 with filler 230 so as to cover the chip 210. The material of the filler 230 is transparent, and can be silicone, for example. The filler 230 can protect the chip 210 and leads 212 connected to the chip 210. The convex lens structure 240 is disposed on the filler 230 and the chip 210. Regarding the embodiment, the focus of the convex lens structure 240 is located on the chip 210. The material of the convex lens structure 240 is silicone or glass. Furthermore, the infrared filter 250 is attached on the incident surface 242 of the convex lens structure 240. The infrared filter 250 can filter infrared rays.

Because the convex lens structure 240 capable of condensing light is disposed above the chip 210, incident sunlight can be focused on the chip 210. Therefore, the chip 210 can absorb much more light, even if the chip has a smaller area. Because the infrared filter 250 is attached to the incident surface 242 of the convex lens structure 240, the infrared band of sunlight can be filtered by the infrared filter 250. The thermal energy does not easily accumulate on the substrate 220 so that the chip 210 thereon has a long working life.

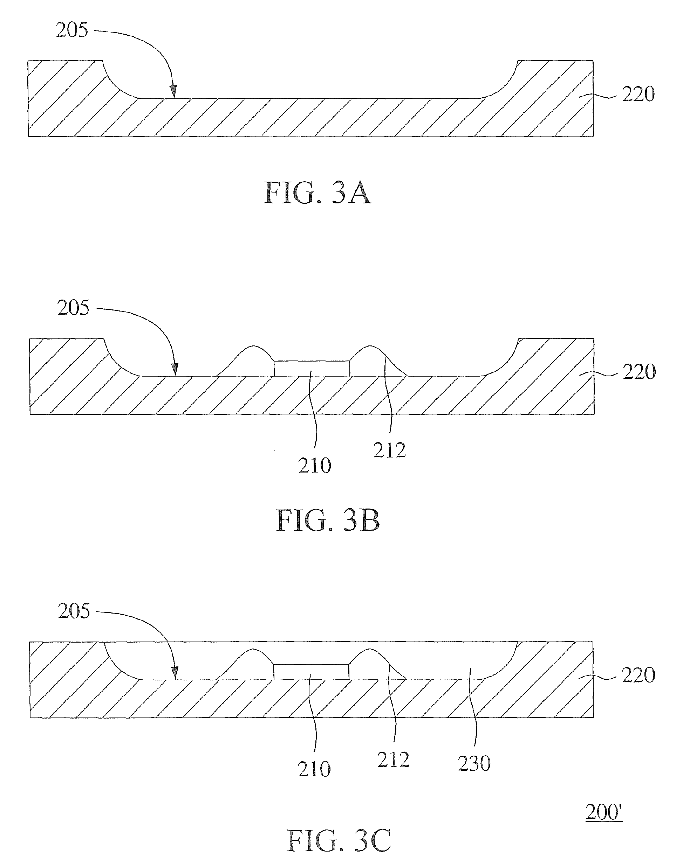

The following descriptions are to explain the manufacturing steps of the solar cell of the embodiment. FIGS. 3A-3E illustrate the manufacturing steps of the solar cell. Referring to FIG. 3A, the substrate 220 which has the groove 205 is provided first. The chip 210 is placed in the groove 205, and the leads 212 are connected to the chip 210, as shown in FIG. 3B. Next, the filler 230 is filled in the groove 205 until the chip 210 and the leads 212 are covered by the filler 230, as shown in FIG. 3C.

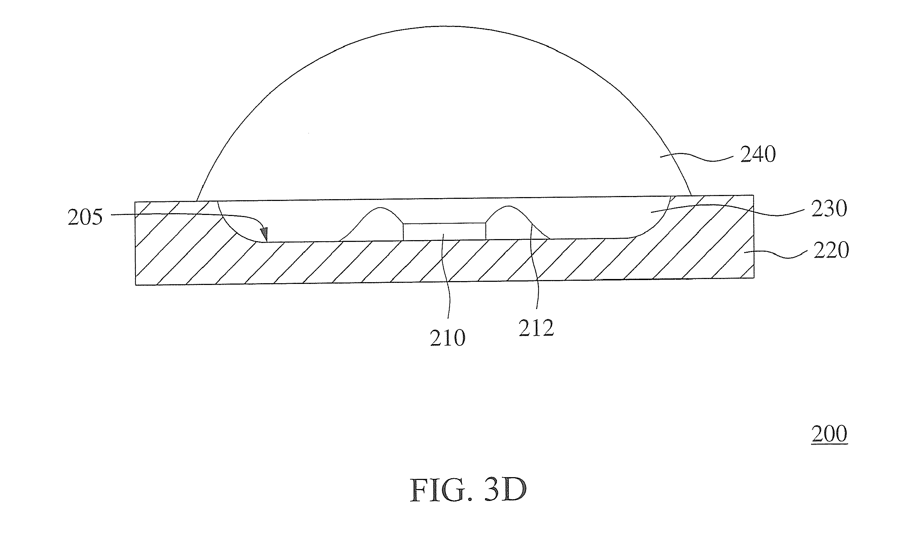

The unfinished solar cell 200' in FIG. 3C is disposed in an injection mold to progress injection molding. The convex lens structure 240 is formed on the groove 205, as shown in FIG. 3D. Because the chip 210 and the leads 212 are protected by the filler 230, the molding flow cannot affect them during the injection molding.

Alternatively, the convex lens structure 240 is formed in advance. For example, the convex lens structure 240 is ground from glass, and then, is attached to the filler 230.

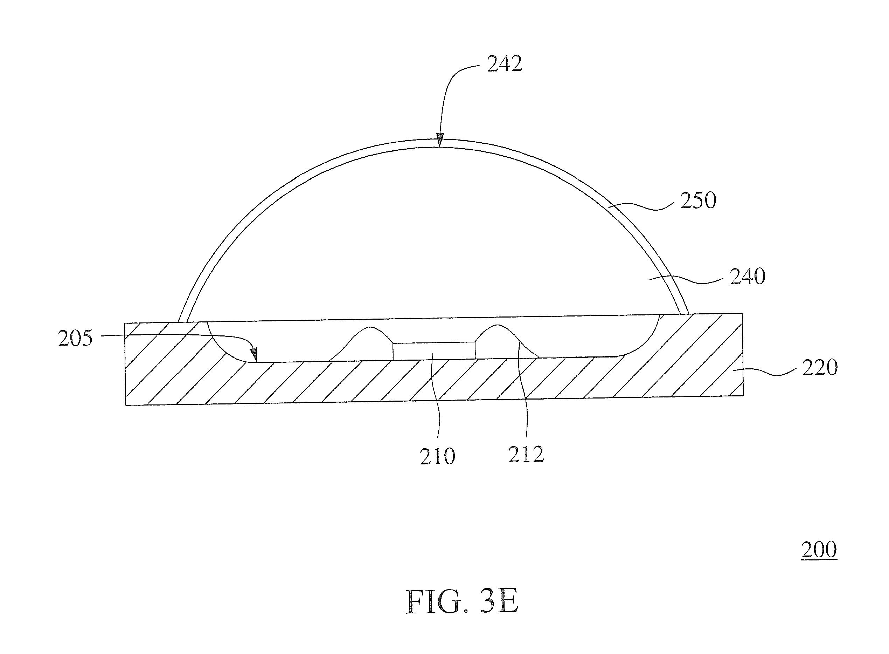

Referring to FIG. 3E, the infrared filter 250 is attached on the incident surface 242 of the convex lens structure 240. The solar cell 200 of the embodiment is finished.

It is worth noting that the main function of the filler 230 is to protect the chip 210 and the leads 212 from the influence of the molding flow during the injection molding. Therefore, the step as shown in FIG. 3C can be eliminated when the convex lens structure 240 is formed in advance.

In summary there is disclosed a solar cell including a substrate, a chip, a convex lens structure, and an infrared filter. The substrate has a groove in which the chip is placed. The chip can transform light energy into electric energy. Furthermore, the convex lens structure is placed over the groove. The infrared filter is attached to the incident surface of the convex lens structure.

Clearly, following the description of the above embodiments, the present invention may have many modifications and variations. Therefore, the scope of the present invention shall be considered with the scopes of the dependent claims. In addition to the above detailed description, the present invention can be broadly embodied in other embodiments. The above-described embodiments of the present invention are intended to be illustrative only, and should not become a limitation of the scope of the present invention. Numerous alternative embodiments may be devised by persons skilled in the art without departing from the scope of the following claims.

## Claims

1. A solar cell (200), comprising:
a substrate (220) having a groove (205);
a chip (210) disposed in the groove and transforming light energy into electric energy;
a convex lens structure (240) disposed above the groove; and
an infrared filter (250) attached on an incident surface (242) of the convex lens structure.

2. The solar cell of Claim 1, wherein the material of the convex lens structure is silicone.

3. The solar cell of Claim 1, wherein the material of the convex lens structure is glass.

4. The solar cell of Claim 1, wherein the focus of the convex lens structure is at the chip.

5. The solar cell of Claim 1, further comprising filler (230) filled in the groove to coverer the chip.

6. The solar cell of Claim 5, wherein the material of the filler is silicone.

7. A method for manufacturing a solar cell (200), comprising the steps of:
providing a substrate (220) having a groove (205);
placing a chip (210) in the groove of the substrate;
placing a convex lens structure (240) above the groove; and
attaching an infrared filter (250) to an incident surface (242) of the convex lens structure.

8. The method for manufacturing a solar cell of Claim 7, wherein the material of the convex lens structure is glass and the convex lens structure is placed above the groove by attachment.

9. The method for manufacturing a solar cell of Claim 7, further comprising a step after the chip is placed in the groove of the substrate and before the convex lens structure is placed above the groove as follows:
filling the groove with filler (230) to cover the chip.

10. The method for manufacturing a solar cell of Claim 9, wherein the material of the filler is silicone.

11. The method for manufacturing a solar cell of Claim 9, wherein the convex lens structure is formed on the filler by injection molding.
